# EUROPEAN PATENT APPLICATION

(11) **EP 4 679 505 A1**
(43) Date of publication of application: **14.01.2026**
(21) Application number: 23926028.4
(22) Date of filing: 17.11.2023
(51) Int. Cl.: H01L 23/48, H01G 2/22

(54) **POWER DEVICE, CAPACITOR, POWER DEVICE ASSEMBLY AND VEHICLE**

(30) Priority: 03.03.2023 CN 202310242356
(71) Applicant: BYD Company Limited, Shenzhen, Guangdong 518118 (CN)
(72) Inventor: LIAN, Yubo, Shenzhen, Guangdong 518118 (CN); LING, Heping, Shenzhen, Guangdong 518118 (CN); LIU, Haijun, Shenzhen, Guangdong 518118 (CN); TANG, Chengbo, Shenzhen, Guangdong 518118 (CN); ZHANG, Haixing, Shenzhen, Guangdong 518118 (CN)
(74) Representative: Mathys & Squire
(86) International application number: PCT/CN2023/132465
(87) International publication number: WO 2024/183333

(57) **Abstract**

A power device, a capacitor, a power device assembly and a vehicle. The power device includes a power device body, a first electric connector and a second electric connector, wherein the first electric connector includes a first electric connection end extending from the power device body in a first direction; the second electric connector includes a second electric connection end extending from the power device body; the direction of current flowing through the first electric connector is set to be opposite to the direction of current flowing through the second electric connector; the first electric connection end and the second electric connection end are stacked in a second direction; and the second direction is perpendicular to the first direction.

## Description

### CROSS-REFERENCE TO RELATED APPLICATIONS

The present disclosure claims priority to the Chinese Patent Application No. 202310242356.5 filed to the China National Intellectual Property Administration on March 3, 2023, entitled "POWER MODULE, CAPACITOR AND POWER MODULE ASSEMBLY AND VEHICLE", which is incorporated herein by reference in its entirety.

### FIELD

The present disclosure relates to the technical field of vehicles, and in particular, to a power device, a capacitor and power device assembly and a vehicle.

### BACKGROUND

In the three core systems of new energy vehicles, the controller is one of the most critical parts, and the support capacitor and the power device are the most important components in the controller. The support capacitor (also called DC-Link capacitor) mainly provides protection for the module (ripple absorbing, etc.), and prevents the module from breaking down due to high voltage. The power device converts the power output to provide three-phase power input for the motor.

In the related art, after the support capacitor and the power device are electrically connected, stray inductance is often high, and the high stray inductance can cause problems such as loss or signal attenuation of the circuit system.

### SUMMARY

An object of the present disclosure is to provide a power device, a capacitor and power device assembly and a vehicle, and the power device can reduce stray inductance and improve the stability and anti-interference ability of the power device.

In order to achieve the above object, a first aspect of the present disclosure provides a power device, including:
a power device body;
a first electrical connector including a first electrical connection end extending from the power device body in a first direction;
a second electrical connector including a second electrical connection end extending from the power device body;
wherein a direction of current flowing through the first electrical connector is set to be opposite to a direction of current flowing through the second electrical connector, the first electrical connection end and the second electrical connection end are stacked in a second direction, and the second direction is perpendicular to the first direction.

According to an embodiment of the present disclosure, a projection of the first electrical connection end in the second direction completely covers a projection of the second electrical connection end in the second direction; or,
the projection of the second electrical connection end in the second direction completely covers the projection of the first electrical connection end in the second direction.

According to an embodiment of the present disclosure, a distance between the first electrical connection end and the second electrical connection end in the second direction is less than or equal to 1 mm.

According to an embodiment of the present disclosure, a width of the first electrical connection end in a third direction is equal to a width of the second electrical connection end in the third direction, and the first direction and the second direction are perpendicular to the third direction.

According to an embodiment of the present disclosure, a length of the first electrical connection end in the first direction is greater than a length of the second electrical connection end in the first direction; or,
the length of the second electrical connection end in the first direction is greater than the length of the first electrical connection end in the first direction.

According to an embodiment of the present disclosure, the power device further includes a first isolation sheet, at least a portion of the first isolation sheet being located between the first electrical connection end and the second electrical connection end, and the projection of at least one of the first electrical connection end and the second electrical connection end in the second direction being completely located within a projection of the first isolation sheet in the second direction.

A second aspect of the present disclosure provides a capacitor and power device assembly, including a capacitor and the power device, the first electrical connection end and the second electrical connection end of the power device being connected to the capacitor.

According to an embodiment of the present disclosure, the capacitor includes a capacitor body, a third electrical connector and a fourth electrical connector, the third electrical connector including a third electrical connection end extending from the capacitor body in the first direction, and the fourth electrical connector including a fourth electrical connection end extending from the capacitor body;
a direction of current flowing through the third electrical connector being set to be opposite to a direction of current flowing through the fourth electrical connector, and the third electrical connection end and the fourth electrical connection end being stacked in the second direction;
wherein the third electrical connection end is connected to the first electrical connection end, and the fourth electrical connection end is connected to the second electrical connection end.

According to an embodiment of the present disclosure, a gap is between an end of the third electrical connection end away from the capacitor body and an end of the first electrical connection end away from the power device body, a first welding region is formed at a connection position between the fourth electrical connection end and the second electrical connection end, and at least a portion of the first welding region is exposed from the gap;
the capacitor and power device assembly further includes an intermediate connector, and the third electrical connection end and the first electrical connection end are connected by the intermediate connector.

According to an embodiment of the present disclosure, the intermediate connector is arranged across the gap, one end of the intermediate connector is connected to the third electrical connection end, and the other end of the intermediate connector is connected to the first electrical connection end.

According to an embodiment of the present disclosure, the intermediate connector includes a main body portion, a first overlapping portion arranged on one side of the main body portion, and a second overlapping portion arranged on the other side of the main body portion, the first overlapping portion being overlapped on the third electrical connection end, and the second overlapping portion being overlapped on the first electrical connection end.

According to an embodiment of the present disclosure, a first positioning portion and a second positioning portion are arranged on the main body portion, the first positioning portion being configured to be aligned with an end face of the end of the third electrical connection end away from the capacitor body, and the second positioning portion being configured to be aligned with an end face of the end of the first electrical connection end away from the power device body.

According to an embodiment of the present disclosure, the main body portion is formed as a U-shaped structure with an opening facing the gap, the first positioning portion is a first inner sidewall or a first outer sidewall of the U-shaped structure close to the first overlapping portion, and the second positioning portion is a second inner sidewall or a second outer sidewall of the U-shaped structure close to the second overlapping portion.

According to an embodiment of the present disclosure, the first overlapping portion is welded to the third electrical connection end by a fusion welding process, a second welding region is between the first overlapping portion and the third electrical connection end, the second overlapping portion being welded to the first electrical connection end by the fusion welding process, and a third welding region being between the second overlapping portion and the first electrical connection end;
a distance between an edge of the second welding region close to the main body portion and the first positioning portion is 1mm to 4mm, and a distance between an edge of the third welding region close to the main body portion and the second positioning portion is 1mm to 4mm.

According to an embodiment of the present disclosure, a first fitting region is between the first overlapping portion and the third electrical connection end, and a second fitting region is between the second overlapping portion and the first electrical connection end;
the first overlapping portion being welded to the third electrical connection end by the fusion welding process, the second welding region being between the first overlapping portion and the third electrical connection end, the second overlapping portion being welded to the first electrical connection end by the fusion welding process, and the third welding region being between the first overlapping portion and the first electrical connection end;
wherein a width of the first fitting region is greater than a width of the second welding region, and a width of the second fitting region is greater than a width of the third welding region.

According to an embodiment of the present disclosure, the width of the first fitting region and the width of the second fitting region are both 4mm to 10mm, and the width of the second welding region and the width of the third welding region are both 0.5mm to 2mm; or,
a ratio of the width of the second welding region to the width of the first fitting region is less than 0.8, and a ratio of the width of the third welding region to the width of the second fitting region is less than 0.8.

According to an embodiment of the present disclosure, the power device further includes the first isolation sheet, at least a portion of the first isolation sheet being located between the first electrical connection end and the second electrical connection end, the capacitor further includes a second isolation sheet, and at least a portion of the second isolation sheet is located between the third electrical connection end and the fourth electrical connection end;
wherein a portion of the first isolation sheet and a portion of the second isolation sheet are stacked in the second direction.

According to an embodiment of the present disclosure, a portion of the first isolation sheet is located between the third electrical connection end and the fourth electrical connection end; and/or,
a portion of the second isolation sheet is located between the first electrical connection end and the second electrical connection end.

A third aspect of the present disclosure provides a vehicle including the capacitor and power device assembly.

In the power device provided by the present disclosure, the first electrical connection end and the second electrical connection end are stacked in the second direction, and the direction of the alternating magnetic field generated by the alternating current in the first electrical connection end is opposite to the direction of the alternating magnetic field generated by the alternating current in the second electrical connection end, so that the alternating magnetic field generated on the first electrical connection end and the alternating magnetic field generated on the second electrical connection end can at least partially cancel each other out, the stray inductance of the power device is reduced, the influence of the stray inductance on the power device and the circuit where the power device is located is reduced, and the anti-interference ability and stability of the power device are improved.

Other features and advantages of the present disclosure will be described in detail in the following detailed description section.

### BRIEF DESCRIPTION OF THE DRAWINGS

The accompanying drawings are intended to provide a further understanding of the present disclosure and constitute a part of the specification and, together with the following detailed description, serve to explain the present disclosure, but cannot be construed as a limitation on the present disclosure. In the drawings:
FIG. 1 is a perspective view of a power device according to an exemplary embodiment of the present disclosure.
FIG. 2 is a perspective view of a capacitor and power device assembly according to an exemplary embodiment of the present disclosure.
FIG. 3 is a perspective view of an intermediate connector of a capacitor and power device assembly according to an exemplary embodiment of the present disclosure.
FIG. 4 is a side view of a capacitor and power device assembly according to an exemplary embodiment of the present disclosure.
FIG. 5 is an enlarged view of the "A" portion of FIG. 4.
FIG. 6 is an enlarged view of a capacitor and power device assembly according to an exemplary embodiment of the present disclosure.
FIG. 7 is a side view of a capacitor and power device assembly according to another exemplary embodiment of the present disclosure.
FIG. 8 is an enlarged view of the "B" portion of FIG. 7.
FIG. 9 is a side view of a capacitor and power device assembly according to another exemplary embodiment of the present disclosure.
FIG. 10 is an enlarged view of the "C" portion of FIG. 9.

### DETAILED DESCRIPTION

Specific embodiments of the present disclosure will be described in detail with reference to the accompanying drawings. It will be understood that the detailed description described herein is for illustration and explanation of the present disclosure only, and is not intended to limit the present disclosure.

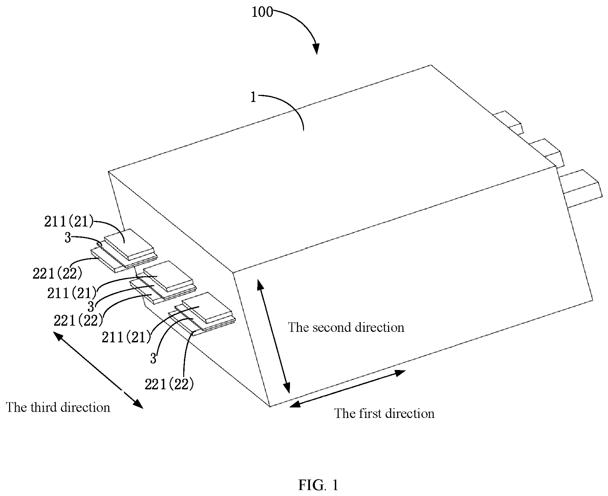

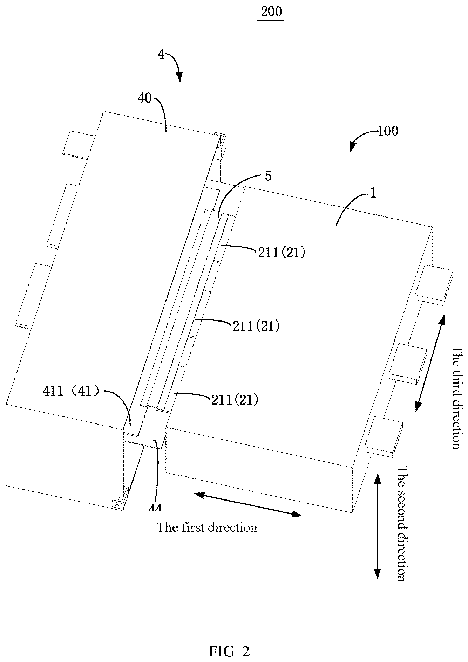

In the present disclosure, unless otherwise described, the orientation words such as "first direction, second direction, and third direction" used in the present disclosure are directions defined to facilitate the description of the structure of the electrical device module, and do not limit the electrical device module, "first direction and second direction" may refer to the first direction and the second direction indicated by arrows in FIGS. 1, 2, 4, 7, and 9, "third direction" may refer to the third direction indicated by arrows in FIGS. 1 and 2, and "inner and outer" refer to the inside and outside of the contour of the related component. In addition, it should be noted that terms such as "first" and "second" are used to distinguish one element from another element, and do not have sequence or importance. In addition, in the description with reference to the drawings, the same reference signs in different drawings indicate the same elements.

In the related art, the function of the power device is to convert the power output and provide three-phase power input to the motor. After the power device is connected to the three-phase alternating current circuit, due to the electromagnetic induction effect of the alternating current, stray inductance will be excited at the connection position of the power device, and the stray inductance will cause an increase in the voltage fluctuation resulting in damage to the power device and affect the safety of the vehicle.

As shown in FIGS. 1 to 10, the first aspect of the present disclosure provides a power device 100. The power device 100 includes a power device body 1, a first electrical connector 21 and a second electrical connector 22, the first electrical connector 21 includes a first electrical connection end 211 extending from the power device body 1 in a first direction, and the second electrical connector 22 includes a second electrical connection end 221 extending from the power device body 1, wherein a direction of current flowing through the first electrical connector 21 is set to be opposite to a direction of current flowing through the second electrical connector 22, the first electrical connection end 211 and the second electrical connection end 221 are stacked in a second direction, and the second direction is perpendicular to the first direction.

In the power device 100 described above, the direction of the current flowing through the first electrical connector 21 is set to be opposite to the direction of the current flowing through the second electrical connector 22, and it is worth noting that the current direction mentioned in the present disclosure does not refer to the flow direction of current in three-dimensional space, but refers to the flow direction of the current in a circuit starting from the power device 100 in the flow path. For example, when the current in the first electrical connector 21 flows from the power device 100 to an external load device, the current in the second electrical connector 22 flows from the external load device to the power device 100, that is, the direction of the current flowing through the first electrical connector 21 is set to be opposite to the direction of the current flowing through the second electrical connector 22.

When the power device 100 is connected to the alternating current circuit, the alternating currents in the first electrical connector 21 and the second electrical connector 22 excite inductance, and since the currents in the first electrical connector 21 and the second electrical connector 22 flow in opposite directions, the direction of the magnetic field generated on the first electrical connector 21 is also opposite to the direction of the magnetic field generated on the second electrical connector 22. Since the first electrical connection end 211 and the second electrical connection end 221 are stacked in the second direction, the direction of the magnetic field generated on the first electrical connection end 211 is opposite to the direction of the magnetic field generated on the second electrical connection end 221, the magnetic field generated on the first electrical connection end 211 and the magnetic field generated on the second electrical connection end 221 can at least partially cancel each other out, stray inductance of the power device 100 is reduced, and the influence of the stray inductance on the power device 100 and the circuit where the power device 100 is located is reduced.

In the embodiment where the power device 100 is applied to a motor controller of a vehicle, since the magnetic field generated on the first electrical connection end 211 and the magnetic field generated on the second electrical connection end 221 can at least partially cancel each other out, stray inductance of the power device 100 can be reduced, and the anti-interference ability of the power device 100 is stronger and the performance is more stable, thereby improving the stability of the vehicle power system and ensuring the safety of the vehicle.

According to the above technical solution, the first electrical connection end 211 and the second electrical connection end 221 are stacked in the second direction, and the direction of the alternating magnetic field generated by the alternating current in the first electrical connection end 211 is opposite to the direction of the alternating magnetic field generated by the alternating current in the second electrical connection end 221, so that the magnetic field generated on the first electrical connection end 211 and the magnetic field generated on the second electrical connection end 221 can at least partially cancel each other out, stray inductance of the power device 100 can be reduced, the influence of the stray inductance on the power device 100 and the circuit where the power device 100 is located is reduced, and the anti-interference ability and stability of the power device 100 are improved.

The inductances between the first electrical connection end 211 and the second electrical connection end 221 interact with each other, and in order to make the magnetic field generated on the first electrical connection end 211 and the magnetic field generated on the second electrical connection end 221 cancel each other out as much as possible, optionally, a projection of the first electrical connection end 211 in the second direction may completely cover a projection of the second electrical connection end 221 in the second direction, or the projection of the second electrical connection end 221 in the second direction completely covers the projection of the first electrical connection end 211 in the second direction. That is, the projection of one of the first electrical connection end 211 and the second electrical connection end 221 in the second direction is completely located within the projection of the other in the second direction, so that the magnetic field generated on one of the first electrical connection end 211 and the second electrical connection end 221 can be cancelled out as much as possible by the magnetic field generated on the other, thereby minimizing stray inductance of the power device 100.

The smaller the distance between the first electrical connection end 211 and the second electrical connection end 221 in the second direction, the better the cancellation effect of the magnetic fields generated on the first electrical connection end 211 and the second electrical connection end 221. In theory, when the first electrical connection end 211 and the second electrical connection end 221 completely overlap, the magnetic fields on the first electrical connection end 211 and the second electrical connection end 221 can be completely cancelled out. In practical applications, optionally, the distance between the first electrical connection end 211 and the second electrical connection end 221 in the second direction may be less than or equal to 1 mm, and in this embodiment, the first electrical connection end 211 and the second electrical connection end 221 can be arranged without position interference, and the inductances in the first electrical connection end 211 and the second electrical connection end 221 can be ensured to have a good cancellation effect. In the embodiment, optionally, the distance between the first electrical connection end 211 and the second electrical connection end 221 in the second direction may be 0.5 mm.

As an exemplary embodiment, as shown in FIGS. 1 and 2, optionally, the width of the first electrical connection end 211 in the third direction is equal to the width of the second electrical connection end 221 in the third direction, and the first direction and the second direction are both perpendicular to the third direction. In the embodiment, the width of the first electrical connection end 211 in the third direction is the same as the width of the second electrical connection end 221 in the third direction, and the width of the current flow path through the first electrical connection end 211 is the same as the width of the current flow path through the second electrical connection end 221, so that the strengths of the magnetic fields generated on the first electrical connection end 211 and the second electrical connection end 221 are close to each other, thereby being able to cancel each other out as much as possible to minimize stray inductance of the power device 100.

In order to facilitate the distinction of the first electrical connection end 211 and the second electrical connection end 221, as shown in FIG. 1, optionally, the length of the first electrical connection end 211 in the first direction is greater than the length of the second electrical connection end 221 in the first direction, or the length of the second electrical connection end 221 in the first direction is greater than the length of the first electrical connection end 211 in the first direction. When the first electrical connection end 211 and the second electrical connection end 221 are respectively connected to the external load device, the operator can distinguish the connection relationship of the first electrical connection end 211 and the second electrical connection end 221 according to the different lengths of the first electrical connection end 211 and the second electrical connection end 221 in the first direction, thereby ensuring that the first electrical connection end 211 and the second electrical connection end 221 can be correctly connected to the external load device. In particular, in the embodiment where the external load device is a high-voltage electrical structure, since the voltage of the load device is high, when a misconnection occurs between the first electrical connection end 211 and the second electrical connection end 221 of the power device 100 and the high-voltage load device, the breakdown, damage or failure of the power device 100 is easily caused. Therefore, in the embodiment, the lengths of the first electrical connection end 211 and the second electrical connection end 221 in the first direction are different, which facilitate the operator to distinguish and identify the first electrical connection end 211 and the second electrical connection end 221, thereby ensuring the correct installation operation of the power device 100.

The voltage polarities on the first electrical connection end 211 and the second electrical connection end 221 are opposite, and in order to realize insulation between the first electrical connection end 211 and the second electrical connection end 221, optionally, the power device 100 can further include a first isolation sheet 3, at least a portion of the first isolation sheet 3 being located between the first electrical connection end 211 and the second electrical connection end 221, and the projection of at least one of the first electrical connection end 211 and the second electrical connection end 221 in the second direction being completely located within the projection of the first isolation sheet 3 in the second direction, thereby ensuring that the first electrical connection end 211 and the second electrical connection end 221 are completely isolated avoiding a short circuit between the first electrical connection end 211 and the second electrical connection end 221, and ensuring the safety of the power device 100. In the embodiment, the first isolation sheet 3 can be made of any material having an insulation function, for example, rubber, nylon, polyethylene material, polypropylene material or polyester material, etc., and the present disclosure does not make a specific limitation thereon.

In the embodiment, optionally, a plurality of first isolation sheets 3 can also be included, and the plurality of first isolation sheets 3 are stacked in the second direction, so as to reduce the risk of the plurality of first isolation sheets 3 being broken down at the same time, improve the stability of the power device 100 when the power device 100 is connected to a high-voltage circuit, and ensure the safety of the power device 100.

As shown in FIGS. 2 to 10, the second aspect of the present disclosure provides a capacitor and power device assembly 200 including the capacitor 4 and the power device 100 described above, and the first electrical connection end 211 and the second electrical connection end 221 of the power device 100 are connected to the capacitor 4.

Optionally, the capacitor 4 can include a capacitor body 40, a third electrical connector 41, and a fourth electrical connector 42. The third electrical connector 41 includes a third electrical connection end 411 extending from the capacitor body 40 in the first direction, the fourth electrical connector 42 includes a fourth electrical connection end 421 extending from the capacitor body 40, the direction of the current flowing through the third electrical connector 41 being set to be opposite to the direction of the current flowing through the fourth electrical connector 42, the third electrical connection end 411 and the fourth electrical connection end 421 being stacked in the second direction, wherein the third electrical connection end 411 is connected to the first electrical connection end 211, and the fourth electrical connection end 421 is connected to the second electrical connection end 221.

In the capacitor and power device assembly 200, the third electrical connection end 411 and the fourth electrical connection end 421 are stacked in the second direction, the currents in the third electrical connector 41 and the fourth electrical connector 42 flow in opposite directions, the direction of the magnetic field generated on the third electrical connector 41 is opposite to the direction of the magnetic field generated on the fourth electrical connector 42, and the magnetic field generated on the third electrical connection end 411 and the magnetic field generated on the fourth electrical connection end 421 can at least partially cancel each other out, so that stray inductance of the capacitor 4 is reduced, and the influence of the stray inductance on the capacitor 4 and the power device 100 is reduced. Therefore, the capacitor and power device assembly 200 provided by the embodiment has good anti-interference ability and stability.

As an exemplary implementation scenario, the capacitor and power device assembly 200 can be applied to a motor controller of a vehicle. One end of the capacitor 4 is electrically connected to the power device 100, and the other end can be electrically connected to a battery pack of the vehicle. Since stray inductance generated in the capacitor and power device assembly 200 is low, the capacitor and power device assembly 200 has little interference and influence on the battery pack or other electrical structures of the vehicle, so that the motor controller of the vehicle has good stability, and the overall safety of the vehicle is improved.

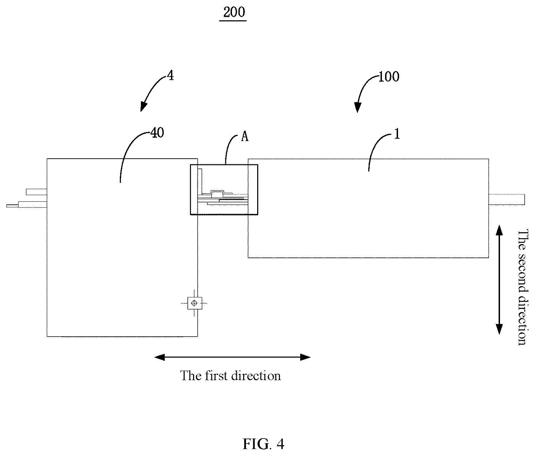

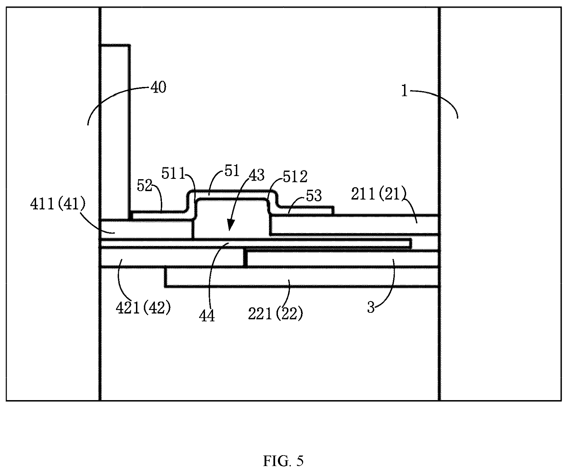

In order to ensure the safety of the capacitor and power device assembly 200, as shown in FIGS. 4 and 5, optionally, the power device 100 can further include the first isolation sheet 3, and at least a portion of the first isolation sheet 3 is located between the first electrical connection end 211 and the second electrical connection end 221 to isolate the currents in the first electrical connection end 211 and the second electrical connection end 221. The capacitor 4 can further include a second isolation sheet 44, and at least a portion of the second isolation sheet 44 is located between the third electrical connection end 411 and the fourth electrical connection end 421 to isolate the currents in the third electrical connection end 411 and the fourth electrical connection end 421. In order to improve the insulation effect, optionally, at least a portion of the first isolation sheet 3 and at least a portion of the second isolation sheet 44 can be stacked in the second direction.

As shown in FIGS. 4 and 5, optionally, a portion of the first isolation sheet 3 is located between the third electrical connection end 411 and the fourth electrical connection end 421. Optionally, a portion of the second isolation sheet 44 is located between the first electrical connection end 211 and the second electrical connection end 221.

In the related art, the capacitor and the power devices are usually connected by bolts. Since the bolt connection needs to occupy a certain space on the connection end of the capacitor and the power device, the connection end has a problem of large size, and the large size of the connection end leads to a long current path, resulting in a large amount of stray inductance in the connection end. In the capacitor and power device assembly 200 provided by the embodiment of the present disclosure, optionally, the first electrical connection end 211 of the power device 100 and the third electrical connection end 411 of the capacitor 4 can be connected by a fusion welding process, and the second electrical connection end 221 of the power device 100 and the fourth electrical connection end 421 of the capacitor 4 can be connected by the fusion welding process. The fusion welding process herein refers to any process such as laser welding, ultrasonic welding, or high-energy particle welding. For example, the laser welding process can be used, that is, the energy source of the welding process is laser. The present disclosure does not make a specific limitation thereon.

Compared with the technical solution of the related art, in the embodiment provided by the present disclosure, the threaded holes can be removed from the first electrical connection end 211 and the second electrical connection end 221 of the power device 100, and the threaded holes can be removed from the third electrical connection end 411 and the fourth electrical connection end 421 of the capacitor 4, so that the overall size of the first electrical connection end 211, the second electrical connection end 221, the third electrical connection end 411 and the fourth electrical connection end 421 can be reduced, the structure of the capacitor and power device assembly 200 is more compact, the current path of the current flowing between the capacitor 4 and the power device 100 is shortened, and thus the stray inductance is reduced, and the overall stability and anti-interference ability of the capacitor and power device assembly 200 are further improved.

In the process of processing the capacitor and power device assembly 200, since the first electrical connection end 211 and the second electrical connection end 221 are stacked, and the third electrical connection end 411 and the fourth electrical connection end 421 are stacked, when the first electrical connection end 211 and the third electrical connection end 411 are subjected to the fusion process, the energy source for the fusion process can be located on the side of the first electrical connection end 211 and the third electrical connection end 411 away from the second electrical connection end 221 and the fourth electrical connection end 421, so as to perform the fusion scanning on the connection position of the first electrical connection end 211 and the third electrical connection end 411. Similarly, when the second electrical connection end 221 and the fourth electrical connection end 421 are subjected to the fusion process, the energy source for the fusion process can be located on the side of the second electrical connection end 221 and the fourth electrical connection end 421 away from the first electrical connection end 211 and the third electrical connection end 411, so as to perform the fusion scanning on the connection position of the second electrical connection end 221 and the fourth electrical connection end 421. Therefore, in the above processing mode, the position of the energy source for the fusion process needs to be adjusted, or the capacitor and power device assembly 200 needs to be rotated as a whole.

In order to simplify the processing of the capacitor and power device assembly 200, as an exemplary embodiment, as shown in FIGS. 2 to 5, optionally, a gap 43 is between the end of the third electrical connection end 411 away from the capacitor body 40 and the end of the first electrical connection end 211 away from the power device body 1, a first welding region 61 is formed at the connection position of the fourth electrical connection end 421 and the second electrical connection end 221, at least a portion of the first welding region 61 is exposed from the gap 43, and the capacitor and power device assembly 200 further includes an intermediate connector 5, and the third electrical connection end 411 and the first electrical connection end 211 are connected by the intermediate connector 5.

In the above embodiment, the gap 43 is between the end of the third electrical connection end 411 away from the capacitor body 40 and the end of the first electrical connection end 211 away from the power device body 1, the energy source for the fusion process can be located on the side of the first electrical connection end 211 and the third electrical connection end 411 away from the second electrical connection end 221 and the fourth electrical connection end 421 to perform scanning, and the energy provided by the energy source can pass through the gap 43 and scan the first welding region 61 at the connection position of the second electrical connection end 221 and the fourth electrical connection end 421. After the first welding region 61 is fusion-welded, the intermediate connector 5 is placed between the third electrical connection end 411 and the first electrical connection end 211, and the energy source can scan the intermediate connector 5 and the third electrical connection end 411, as well as the intermediate connector 5 and the first electrical connection end 211, respectively. Therefore, when the capacitor and power device assembly 200 is processed, the capacitor and the power device assembly 200 can be processed without adjusting or changing the position of the capacitor and the power device assembly 200 or the energy source in a wide range, so that the processing of the capacitor and power device assembly 200 is simplified, and the production efficiency is improved.

It should be noted that the connection of the intermediate connector 5 with the first electrical connection end 211 and the third electrical connection end 411 is not limited to the aforementioned fusion welding process, and can also be connected by bonding, snapping or screwing process, and the present disclosure does not make a specific limitation thereon. The connection between the second electrical connection end 221 and the fourth electrical connection end 421 is also not limited to the fusion welding process, and can also be connected by bonding, snapping or screwing process. The gap 43 between the first electrical connection end 211 and the third electrical connection end 411 can reserve an operation space for the connection of the second electrical connection end 221 and the fourth electrical connection end 421, so that the operator can process the second electrical connection end 221 and the fourth electrical connection end 421 from the side of the first electrical connection end 211 and the third electrical connection end 411 away from the second electrical connection end 221 and the fourth electrical connection end 421, and also can avoid adjusting or changing the position of the capacitor and the power device assembly 200 or the energy source in a wide range, so as to simplify the processing of the capacitor and power device assembly 200.

In the embodiment, optionally, the intermediate connector 5 can be arranged across the gap 43 to cover the gap 43, one end of the intermediate connector 5 is connected to the third electrical connection end 411, and the other end of the intermediate connector 5 is connected to the first electrical connection end 211. The one end of the intermediate connector 5 and the third electrical connection end 411 can be face-to-face butted, or can be stacked and overlapped, and the other end of the intermediate connector 5 and the first electrical connection end 211 can be face-to-face butted, or can be stacked and overlapped, and the present disclosure does not make a specific limitation thereon.

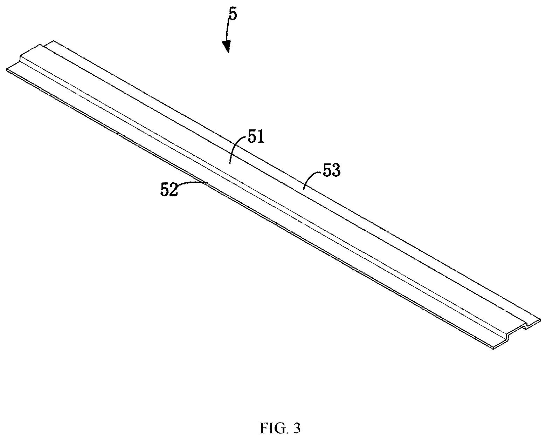

As an exemplary embodiment, as shown in FIGS. 3 and 5, optionally, the intermediate connector 5 can include a main body portion 51, a first overlapping portion 52 arranged on one side of the main body portion 51, and a second overlapping portion 53 arranged on the other side of the main body portion 51, the first overlapping portion 52 being overlapped on the third electrical connection end 411, and the second overlapping portion 53 being overlapped on the first electrical connection end 211.

In order to facilitate the positioning of the first overlapping portion 52 and the second overlapping portion 53, optionally, a first positioning portion 511 and a second positioning portion 512 are arranged on the main body portion 51, the first positioning portion 511 is configured to be aligned with the end face of the end of the third electrical connection end 411 away from the capacitor body 40, and the second positioning portion 512 is configured to be aligned with the end face of the end of the first electrical connection end 211 away from the power device body 1.

The first positioning portion 511 and the second positioning portion 512 can be positioning lines, positioning grooves, or positioning surfaces, etc. As an exemplary embodiment, optionally, the main body portion 51 is formed as a U-shaped structure with an opening facing the gap 43, the first positioning portion 511 is a first inner sidewall or a first outer sidewall of the U-shaped structure close to the first overlapping portion 52, and the second positioning portion 512 is a second inner sidewall or a second outer sidewall of the U-shaped structure close to the second overlapping portion 53.

In the embodiment where the capacitor 4 and the power device 100 are processed by the fusion process, optionally, the first overlapping portion 52 is welded to the third electrical connection end 411 by the fusion welding process, and a second welding region 62 is between the first overlapping portion 52 and the third electrical connection end 411. The second overlapping portion 53 is welded to the first electrical connection end 211 by the fusion welding process, and a third welding region 63 is between the second overlapping portion 53 and the first electrical connection end 211.

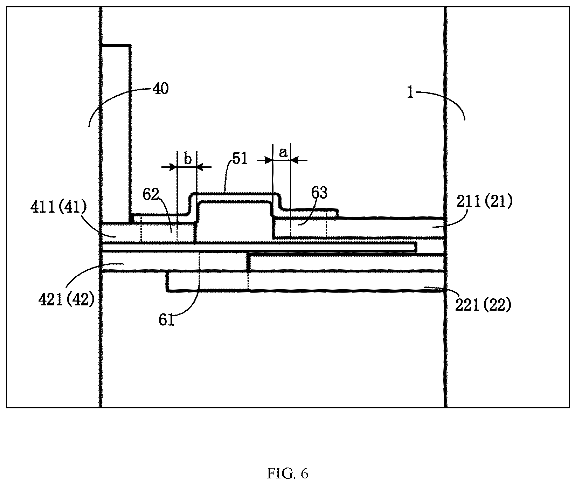

As shown in FIG. 6, the positions of the first welding region 61, the second welding region 62, and the third welding region 63 are exemplarily illustrated by the dotted lines in FIG. 6. Optionally, a distance a between the edge of the second welding region 62 close to the main body portion 51 and the first positioning portion 511 can be 1mm to 4mm, so as to ensure good current transmission efficiency between the first electrical connection end 211 and the third electrical connection end 411. Optionally, a distance b between the edge of the third welding region 63 close to the main body portion 51 and the second positioning portion 512 can be 1mm to 4mm, so as to ensure good current transmission efficiency between the second electrical connection end 221 and the fourth electrical connection end 421.

In the embodiment where the capacitor 4 and the power device 100 are processed by the fusion process, optionally, a first fitting region is between the first overlapping portion 52 and the third electrical connection end 411, that is, the first electrical connector 21 is not fitted by the first overlapping portion 52 at a position outside the first fitting region. Optionally, the width of the first fitting region can be greater than the width of the second welding region 62, so that when the external energy source scans the second welding region 62, the energy provided by the energy source can fall within the first fitting region to avoid the energy provided by the energy source from deviating and scanning other regions of the first electrical connection end 211 causing damage to the first electrical connection end 211. Similarly, optionally, a second fitting region is between the second overlapping portion 53 and the first electrical connection end 211, and the width of the second fitting region can be greater than the width of the third welding region 63, thereby avoiding the energy source from deviating and scanning other regions of the third electrical connection end 411 causing damage to the third electrical connection end 411.

In the embodiment, optionally, the width of the first fitting region and the width of the second fitting region can be 4mm to 10mm, and the width of the second welding region 62 and the width of the third welding region 63 can be 0.5mm to 2mm. Optionally, the ratio of the width of the second welding region 62 to the width of the first fitting region is less than 0.8, and the ratio of the width of the third welding region 63 to the width of the second fitting region is less than 0.8.

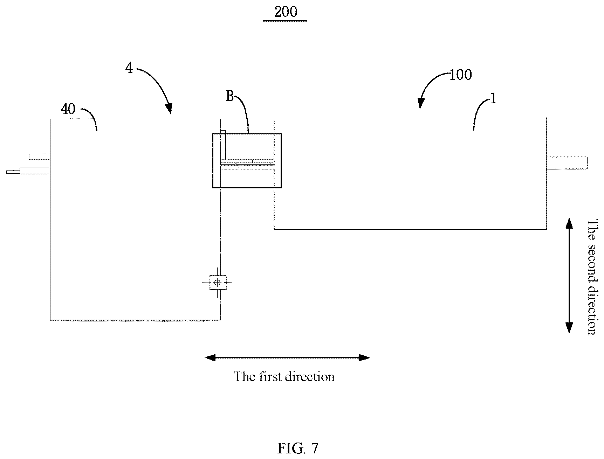

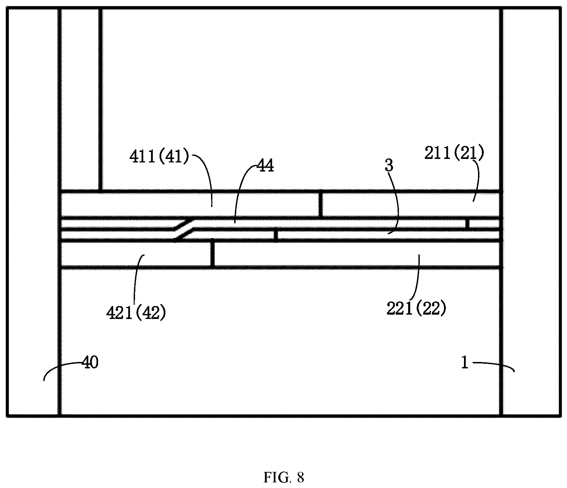

As shown in FIGS. 7 and 8, optionally, the end face of the end of the first electrical connection end 211 away from the power device body 1 can be butted with the end face of the end of the third electrical connection end 411 away from the capacitor body 40, and the end face of the end of the second electrical connection end 221 away from the power device body 1 can be butted with the end face of the end of the fourth electrical connection end 421 away from the capacitor body 40, so as to effectively improve the stability of the connection by using the connection mode of face-to-face fitting. In the connection process, the end face of the end of the first electrical connection end 211 away from the power device body 1 and the end face of the end of the third electrical connection end 411 away from the capacitor body 40 need to be as flat as possible to reduce the gap between the butting faces, for example, the gap between the two end faces may not exceed 0.2mm to improve the stability of the connection.

In the embodiment, optionally, the two surfaces of the first electrical connection end 211 opposite in the second direction are flush with the two surfaces of the third electrical connection end 411 opposite in the second direction respectively, and the two surfaces of the second electrical connection end 221 opposite in the second direction are flush with the two surfaces of the fourth electrical connection end 421 opposite in the second direction respectively, so as to ensure that the current does not suddenly change during the flow process, improve the stability of the current, and further improve the stability of the connection.

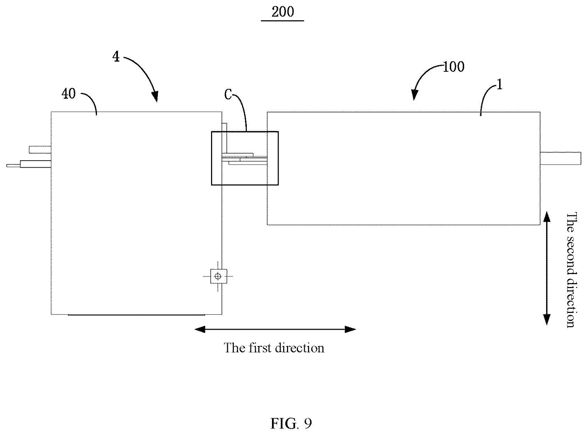

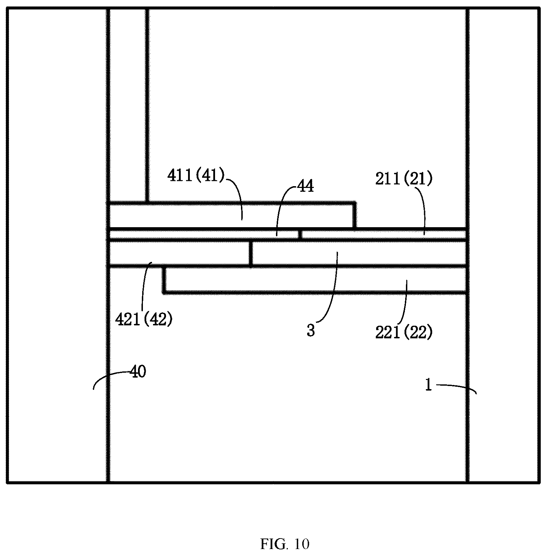

As another exemplary embodiment, as shown in FIGS. 9 and 10, optionally, the end of the first electrical connection end 211 away from the power device body 1 is overlapped with the end of the third electrical connection end 411 away from the capacitor body 40, and the end of the second electrical connection end 221 away from the power device body 1 is overlapped with the end of the fourth electrical connection end 421 away from the capacitor body 40.

For the current stability, optionally, the length of the overlapping region of the first electrical connection end 211 and the third electrical connection end 411 in the first direction is 2mm to 8mm, and the length of the overlapping region of the second electrical connection end 221 and the fourth electrical connection end 421 in the first direction is 2mm to 8mm. In the embodiment, the current between the first electrical connection end 211 and the third electrical connection end 411 and the current between the second electrical connection end 221 and the fourth electrical connection end 421 are stable, and a processing space can be reserved for the fusion process between the first electrical connection end 211 and the third electrical connection end 411, as well as between the second electrical connection end 221 and the fourth electrical connection end 421.

The third aspect of the present disclosure provides a vehicle including the capacitor and power device assembly 200. The vehicle can be an electric vehicle, a hybrid vehicle, a new energy vehicle, etc., and the present disclosure does not make a specific limitation thereon. Since the capacitor and power device assembly 200 provided by the embodiment of the present disclosure has the advantages of strong anti-interference ability and high stability, the vehicle using the capacitor and power device assembly 200 has good stability and safety.

The preferred embodiments of the present disclosure are described in detail above with reference to the drawings, but the present disclosure is not limited to the specific details in the above embodiments. Within the technical concept of the present disclosure, various simple modifications can be made to the technical solutions of the present disclosure, and these simple modifications all belong to the protection scope of the present disclosure.

In addition, it should be noted that the various technical features described in the above embodiments can be combined with each other in any appropriate manner without contradiction. In order to avoid unnecessary repetition, various possible combinations are not described again in the present disclosure.

In addition, various different embodiments of the present disclosure can also be combined with each other as long as they do not contradict the concept of the present disclosure, and should be considered as disclosed in the present disclosure.

## Claims

1. A power device (100), comprising:
a power device body (1);
a first electrical connector (21) comprising a first electrical connection end (211) extending from the power device body (1) in a first direction;
a second electrical connector (22) comprising a second electrical connection end (221) extending from the power device body (1);
wherein a direction of current flowing through the first electrical connector (21) is set to be opposite to a direction of current flowing through the second electrical connector (22), the first electrical connection end (211) and the second electrical connection end (221) are stacked in a second direction, and the second direction is perpendicular to the first direction.

2. The power device (100) according to claim 1, wherein a projection of the first electrical connection end (211) in the second direction completely covers a projection of the second electrical connection end (221) in the second direction; or,
the projection of the second electrical connection end (221) in the second direction completely covers the projection of the first electrical connection end (211) in the second direction.

3. The power device (100) according to claim 1 or 2, wherein a distance between the first electrical connection end (211) and the second electrical connection end (221) in the second direction is less than or equal to 1 mm.

4. The power device (100) according to any one of claims 1 to 3, wherein a width of the first electrical connection end (211) in a third direction is equal to a width of the second electrical connection end (221) in the third direction, and the first direction and the second direction are perpendicular to the third direction.

5. The power device (100) according to any one of claims 1 to 4, wherein a length of the first electrical connection end (211) in the first direction is greater than a length of the second electrical connection end (221) in the first direction; or,
the length of the second electrical connection end (221) in the first direction is greater than the length of the first electrical connection end (211) in the first direction.

6. The power device (100) according to any one of claims 1 to 5, further comprising a first isolation sheet (3), at least a portion of the first isolation sheet (3) being located between the first electrical connection end (211) and the second electrical connection end (221), and the projection of at least one of the first electrical connection end (211) and the second electrical connection end (221) in the second direction being completely located within a projection of the first isolation sheet (3) in the second direction.

7. A capacitor and power device assembly (200), comprising a capacitor (4) and the power device (100) according to any one of claims 1 to 6, the first electrical connection end (211) and the second electrical connection end (221) of the power device (100) being connected to the capacitor (4).

8. The capacitor and power device assembly (200) according to claim 7, wherein the capacitor (4) comprises a capacitor body (40), a third electrical connector (41) and a fourth electrical connector (42), the third electrical connector (41) comprises a third electrical connection end (411) extending from the capacitor body (40) in the first direction, and the fourth electrical connector (42) comprises a fourth electrical connection end (421) extending from the capacitor body (40);
a direction of current flowing through the third electrical connector (41) is set to be opposite to a direction of current flowing through the fourth electrical connection end (421), and the third electrical connection end (411) and the fourth electrical connection end (421) are stacked in the second direction;
wherein the third electrical connection end (411) is connected to the first electrical connection end (211), and the fourth electrical connection end (421) is connected to the second electrical connection end (221).

9. The capacitor and power device assembly (200) according to claim 8, wherein a gap (43) is between an end of the third electrical connection end (411) away from the capacitor body (40) and an end of the first electrical connection end (211) away from the power device body (1), a first welding region (61) is formed at a connection position between the fourth electrical connection end (421) and the second electrical connection end (221), and at least a portion of the first welding region (61) is exposed from the gap (43);
the capacitor and power device assembly (200) further comprises an intermediate connector (5), and the third electrical connection end (411) and the first electrical connection end (211) are connected by the intermediate connector (5).

10. The capacitor and power device assembly (200) according to claim 9, wherein the intermediate connector (5) is arranged across the gap (43), one end of the intermediate connector (5) is connected to the third electrical connection end (411), and the other end of the intermediate connector (5) is connected to the first electrical connection end (211).

11. The capacitor and power device assembly (200) according to claim 10, wherein the intermediate connector (5) comprises a main body portion (51), a first overlapping portion (52) arranged on one side of the main body portion (51), and a second overlapping portion (53) arranged on the other side of the main body portion (51), the first overlapping portion (52) being overlapped on the third electrical connection end (411), and the second overlapping portion (53) being overlapped on the first electrical connection end (211).

12. The capacitor and power device assembly (200) according to claim 11, wherein a first positioning portion (511) and a second positioning portion (512) are arranged on the main body portion (51), the first positioning portion (511) is configured to be aligned with an end face of the end of the third electrical connection end (411) away from the capacitor body (40), and the second positioning portion (512) is configured to be aligned with an end face of the end of the first electrical connection end (211) away from the power device body (1).

13. The capacitor and power device assembly (200) according to claim 12, wherein the main body portion (51) is formed as a U-shaped structure with an opening facing the gap (43), the first positioning portion (511) is a first inner sidewall or a first outer sidewall of the U-shaped structure close to the first overlapping portion (52), and the second positioning portion (512) is a second inner sidewall or a second outer sidewall of the U-shaped structure close to the second overlapping portion (53).

14. The capacitor and power device assembly (200) according to claim 12 or 13, wherein the first overlapping portion (52) is welded to the third electrical connection end (411) by a fusion welding process, a second welding region (62) is between the first overlapping portion (52) and the third electrical connection end (411), the second overlapping portion (53) is welded to the first electrical connection end (211) by the fusion welding process, and a third welding region (63) is between the second overlapping portion (53) and the first electrical connection end (211);
a distance between an edge of the second welding region (62) close to the main body portion (51) and the first positioning portion (511) is 1mm to 4mm, and a distance between an edge of the third welding region (63) close to the main body portion (51) and the second positioning portion (512) is 1mm to 4mm.

15. The capacitor and power device assembly (200) according to any one of claims 11 to 13, wherein a first fitting region is between the first overlapping portion (52) and the third electrical connection end (411), and a second fitting region is between the second overlapping portion (53) and the first electrical connection end (211);
the first overlapping portion (52) is welded to the third electrical connection end (411) by the fusion welding process, the second welding region (62) is between the first overlapping portion (52) and the third electrical connection end (411), the second overlapping portion (53) is welded to the first electrical connection end (211) by the fusion welding process, and the third welding region (63) is between the second overlapping portion (53) and the first electrical connection end (211);
wherein a width of the first fitting region is greater than a width of the second welding region (62), and a width of the second fitting region is greater than a width of the third welding region (63).

16. The capacitor and power device assembly (200) according to claim 15, wherein the width of the first fitting region and the width of the second fitting region are both 4mm to 10mm, and the width of the second welding region (62) and the width of the third welding region (63) are both 0.5mm to 2mm; or,
a ratio of the width of the second welding region (62) to the width of the first fitting region is less than 0.8, and a ratio of the width of the third welding region (63) to the width of the second fitting region is less than 0.8.

17. The capacitor and power device assembly (200) according to any one of claims 8 to 13, wherein the power device (100) further comprises the first isolation sheet (3), at least a portion of the first isolation sheet (3) is located between the first electrical connection end (211) and the second electrical connection end (221), the capacitor (4) further comprises a second isolation sheet (44), and at least a portion of the second isolation sheet (44) is located between the third electrical connection end (411) and the fourth electrical connection end (421);
wherein a portion of the first isolation sheet (3) and a portion of the second isolation sheet (44) are stacked in the second direction.

18. The capacitor and power device assembly (200) according to claim 17, wherein a portion of the first isolation sheet (3) is located between the third electrical connection end (411) and the fourth electrical connection end (421); and/or,
a portion of the second isolation sheet (44) is located between the first electrical connection end (211) and the second electrical connection end (221).

19. A vehicle, comprising the capacitor and power device assembly (200) according to any one of claims 7 to 18.
